# FASCICULE DE BREVET EUROPEEN

(11) **EP 0 621 600 B1**
(45) Date de publication et mention de la délivrance du brevet: **08.07.1998**
(21) Numéro de dépôt: 94400797.0
(22) Date de dépôt: 13.04.1994
(51) Int. Cl.: G11B 33/12

(54) **Structure physique d'un sous-système de mémoire de masse**
Physische Anordnung einer Untergruppe von Speichereinheit
Physical network for a storage unit in a cluster system

(30) Priorité: 22.04.1993 FR 9304772
(43) Date de publication de la demande: 26.10.1994
(73) Titulaire: BULL S.A., 92800 Puteaux (FR)
(72) Inventeur: Carteau, Daniel, F-78180 Montigny le Bretonneux (FR); Michaud, Gilbert, F-78580 Maule (FR)
(74) Mandataire: Gouesmel, Daniel

(56) Documents cités:
- EP-A- 0 356 977
- EP-A- 0 421 847
- EP-A- 0 442 642
- EP-A- 0 488 679
- WO-A-88/06780
- US-A- 5 173 819

## Description

La présente invention concerne une structure physique d'un sous-système de mémoire de masse. Elle est applicable à tout type de système informatique.

Les systèmes informatiques modernes sont de plus en plus complexes. Ils se composent d'un système central occupant une position géographique déterminée, autour duquel gravite des systèmes secondaires localisés en des endroits géographiques différents de celui occupé par le système central. La structure d'un système, qu'il soit central ou secondaire est faite d'au moins une unité centrale, encore appelée hôte, reliée à différents organes périphériques, parmi lesquels se trouvent les mémoires magnétiques de masse, par exemple, les mémoires à disques rotatifs. Le rôle de ces mémoires magnétiques de masse, en particulier des mémoires à disques est de stocker les informations destinées à être traitées par le système informatique vu dans son ensemble, c'est-à-dire composé des systèmes central et secondaire, lorsqu'un usager situé en un lieu géographique quelconque en fait la demande.

Les mémoires à disques magnétiques rotatifs restent pour longtemps encore très largement utilisées car elles permettent d'emmagasiner de très grandes quantités d'informations et d'y accéder relativement rapidement. De plus, les progrès technologiques accomplis notamment dans le domaine des milieux d'enregistrement magnétique et des têtes d'enregistrement permettent de réaliser des mémoires à disques ayant une capacité de l'ordre du demi-gigabyte, dans des volumes physiques de plus en plus réduits. On développe ainsi aujourd'hui des mémoires à disques dont le diamètre des disques et de l'ordre de 2,5 pouces. On peut d'ores et déjà envisager que dans les années qui viennent, la capacité de telles mémoires dont la dimension physique est de l'ordre de celle d'un paquet de cigarettes, pourra atteindre le gigabyte.

Les systèmes informatiques traitent des volumes de données très importants ce qui nécessite l'utilisation d'un nombre toujours plus grand de mémoires de masse où doivent être stockées ces données avant d'être traitées par les processeurs centraux de ceux-ci.

Il en résulte que la gestion d'un tel système dans son ensemble par sa seule unité centrale est extrêmement lourde.

On est donc conduit à la décentraliser au niveau de plusieurs sous-systèmes gérant chacun une partie des éléments du système, en particulier les périphériques.

Pour ce faire, on constitue des sous-systèmes périphériques de mémoire de masse gérant, en lieu et place de l'unité centrale, non seulement le transfert des données de celle-ci vers les mémoires de masse, mais aussi l'écriture et la lecture des informations à l'intérieur de celles-ci.

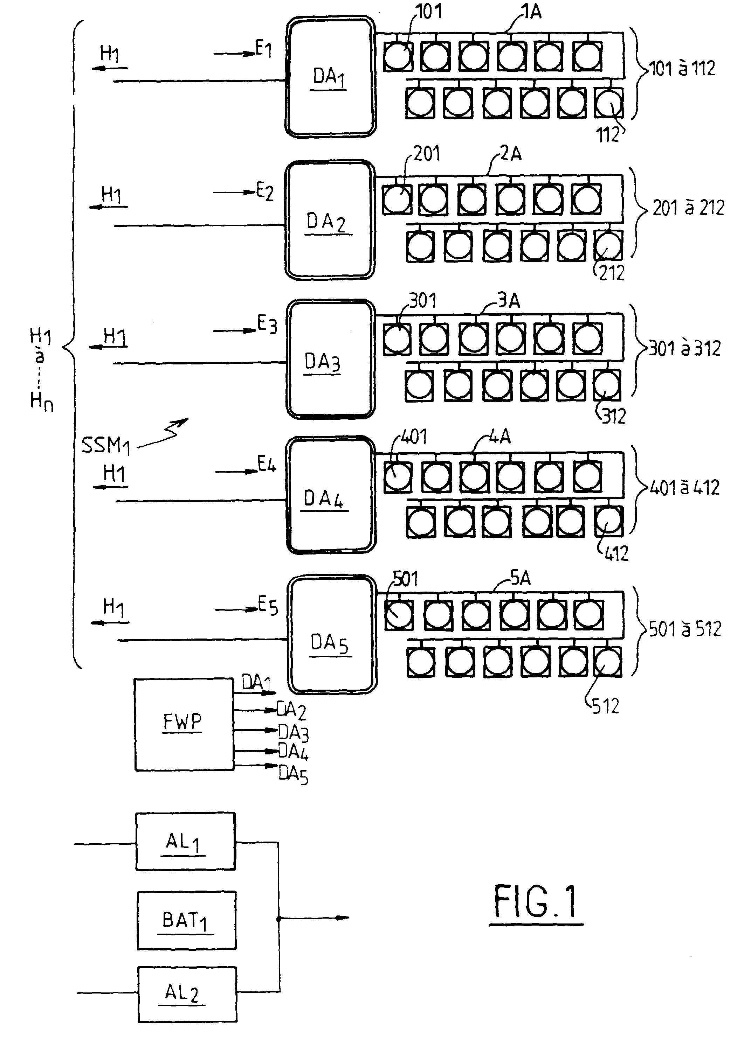

Les figures 1 à 3 montrent des exemples de réalisation de tels systèmes.

On considère tout d'abord la figure 1.

Le sous-système SSM₁ comprend 1 à 5 ensembles identiques E1 à E5.

L'ensemble E₁ se compose d'un dispositif adaptateur DA₁ qui est chargé de la connexion, vers un ou plusieurs hôtes H₁,..., Hₙ, d'un ensemble d'au maximum 12 mémoires à disques à savoir les mémoires à disques 101 à 112. Les douze mémoires sont reliées entre elles au moyen d'une même chaîne de liaison 1A. Le système de branchement des mémoires à disques sur la liaison 1A est tel que si l'une d'entre elles est déconnectée, l'ensemble des autres continue à fonctionner.

Les ensembles E₂ à E₅ ont une structure identique à l'ensemble E₁. Ainsi, l'ensemble E₂ se compose d'un dispositif adaptateur DA₂ est de 12 mémoires à disques 201 à 212 reliées à une même chaîne de liaison 2A. Il en est de même pour les autres ensembles E₃ à E₅, ce dernier étant composé d'un dispositif adaptateur DA₅ associé à 12 mémoires à disques 601 à 612 connectées à une même chaîne 5A.

Afin d'assurer le maximum de sécurité au fonctionnement des ensembles E₁ à E₅, on associe au sous-système SSM₁ deux alimentations électriques identiques AL₁ et AL₂, ainsi qu'une batterie de secours BAT₁. Cela signifie que si l'une des deux alimentations AL₁ et AL₂ tombe en panne, l'autre la remplace, ou encore que si l'alimentation secteur s'interrompt, c'est la batterie BAT₁ qui continue à assurer l'alimentation électrique de chacun des sous-ensembles E₁ à E₅ pendant un temps déterminé et programmable.

Cette redondance d'alimentation et la batterie sont optionnelles, elles sont requises lors du fonctionnement des mémoires à disques en mode connu dit "d'écriture rapide (Fast write)". Un exemple de mode d'écriture rapide est donné dans la demande de brevet français 89 1711 du 22/12/89, déposée par la demanderesse. Par ailleurs, SSM₁ comporte un processeur d'écriture rapide FWP, qui surveille en permanence l'état de fonctionnement de AL₁, AL₂, BAT et autorise ou non, en fonction de cet état, le mode "écriture rapide" ou le mode d'écriture normal.

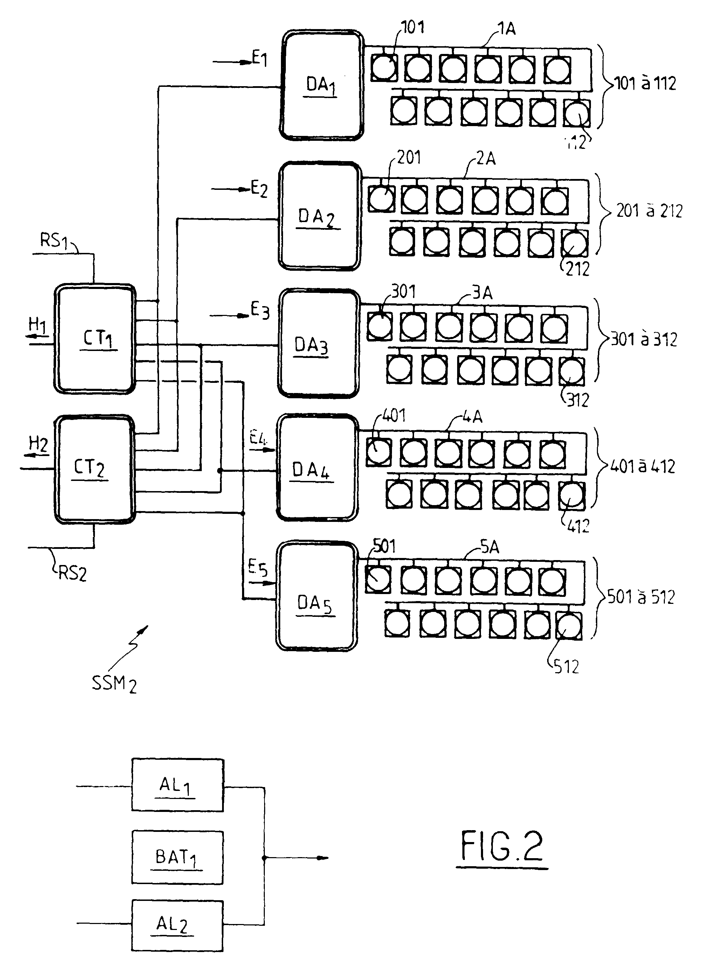

On considère la figure 2 qui montre un second sous-système de mémoire de masse SSM₂ de type standard RAID.

Ce système comprend un premier contrôleur CT₁ relié au moins à un premier hôte central H₁ (à des hôtes H₁,..., Hₙ) et un second contrôleur CT₂ relié au moins, à un hôte central H₂ (à des hôtes H₁,..., Hₙ). Le contrôleur CT₁ peut être par ailleurs relié par une liaison de type RS232 à une console de maintenance / configuration ou à un modem, tandis que le second contrôleur CT₂ est relié par une liaison RS₂₃₂ de même type que la précédente à une console de maintenance / configuration ou à un modem. On rappelle que la liaison de type RS232 est normalisée. Chacun des deux contrôleurs CT₁ et CT₂ est relié à cinq ensembles E₁ à E₅ strictement identiques aux ensembles E₁ à E₅ de la figure 1. Le rôle des dispositifs adaptateurs DA₁ à DA₅ est identique à celui des mêmes dispositifs adaptateurs de la figure 1. On voit donc que le système SSM₂ est redondant, ce qui signifie qu'en cas de panne de l'un des deux contrôleurs, le second supporte l'intégralité de la charge du sous-système. De même qu'à la figure 1, le sous-système SSM₂ comprend deux alimentations électriques AL₁ et AL₂, ainsi qu'une batterie de secours BAT₁. On voit donc que le sous-système SSM₂ est un système sécurisé et fiable du fait de la redondance, du doublement des alimentations, et de la possibilité de changer (grâce à la fonction RAID), l'une quelconque des mémoires à disques de l'un quelconque des ensembles E₁ à E₅ sans interrompre le fonctionnement des autres. On dit encore que le sous-système SSM₂ présente une disponibilité totale.

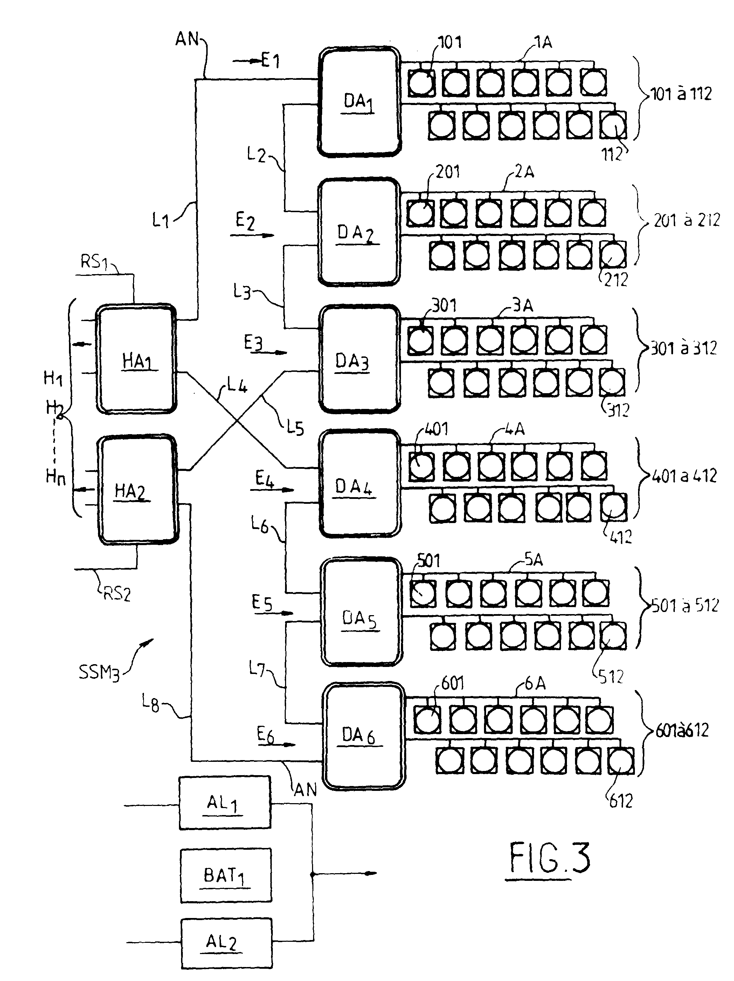

On considère désormais la figure 3 qui montre un troisième exemple de sous-système RAID de mémoire de masse, à savoir SSM₃ dont la structure nouvelle est proposée par la demanderesse. Ce sous-système comporte deux adaptateurs hôtes HA₁ et HA₂, reliés à deux (ou davantage H₁,..., Hₙ) hôtes centraux H₁ et H₂, dont le rôle de gérer l'échange de données entre l'un ou l'autre des deux hôtes centraux H₁ et H₂ et l'ensemble des dispositifs adaptateurs du sous-système. Chacun de ces adaptateurs hôte est connecté de la manière suivante à six sous-ensembles E₁ à E₆ totalement identiques dans leur structure mécanique aux ensembles de même dénomination des figures 1 et 2. Le premier ensemble E₁ se compose du dispositif adaptateur DA₁ associé aux mémoires à disques 101 à 112 connectées à la chaîne de liaison 1A, et ainsi de suite jusqu'à l'ensemble E6 composé du dispositif adaptateur DA₆ associé aux mémoires à disques 601 à 612 connectées à la chaine de liaison 6A. La structure qui relie les adaptateurs hôtes HA₁ et HA₂ aux six sous-ensembles E₁ à E₆ est une structure en anneau. Cet anneau est désigné par AN. Ainsi, le premier adaptateur hôte HA₁ est relié d'une part par l'intermédiaire de la liaison L₁ au dispositif DA₁ de l'ensemble E₁. DA₁ est relié par la liaison L₂ à DA₂, lequel est relié par la liaison L₃ au dispositif adaptateur DA₃ lui-même relié par la liaison L₅ au second adaptateur hôte HA₂. Le premier adaptateur hôte HA₁ est encore relié par la liaison L₄ au dispositif adaptateur DA₄ de l'ensemble EA₄. DA₄ est lui-même relié par la liaison L₆ au dispositif adaptateur DA₅ lequel est lui-même relié par la liaison L₇ au dispositif adaptateur DA₆ de l'ensemble EA₆. Ce dernier dispositif adaptateur est relié par la liaison L₈ au second adaptateur hôte HA₂. On voit donc que l'on réalise bien une structure en anneau AN reliant les deux adaptateurs hôte HA₁ et HA₂ aux différents dispositifs adaptateurs DA₁ à DA₆. De même que les sous-systèmes SSM₁ et SSM₂, le sous-système SSM₃ comprend deux alimentations électriques AL₁ et AL₂, associées à une batterie de secours BAT₁. Le sous-système SSM₃ présente les mêmes avantages que le sous-système SSM₂ en ce qui concerne la disponibilité et la sécurisation des données. Il est cependant beaucoup plus performant et évolutif.

La présente invention concerne une structure physique extrêmement compacte sous forme de tiroir comportant plusieurs plaques, pouvant contenir l'un ou l'autre des trois sous-systèmes montrés aux figures 1 à 3, avec la possibilité de passer d'un type de système à l'autre, pour un même tiroir sur le site même où celui-ci se trouve (cette propriété est connue de l'homme de l'art, sous le terme anglo-saxon de "upgradability"). Pour cela, il suffit de changer simplement un fond de panier que comporte le tiroir. Par ailleurs, cette structure physique permet une très haute disponibilité du sous-système de mémoire de masse, grâce au nombre réduit d'éléments, à la non propagation des pannes, à la redondance. Par ailleurs, on peut remplacer n'importe quelle unité à disques sans interrompre le fonctionnement du sous-système (lorsque l'on est en mode RAID, SSM2, SSM3) et il est possible de changer la plupart des éléments de l'ensemble en fonctionnement sans arrêter celui-ci (fonctionnement non-stop).

Un exemple de réalisation d'une structure physique d'un sous système de mémoire de masse rélié à au moins un système hôte est divulgué dans US-A-5 173 819. Le préambule de la revendication 1 est basé sur ce document.

Selon l'invention, la structure physique d'un sous-système de mémoire de masse relié à au moins un système hôte et comprenant :
- une pluralité de groupement d'unités à disques amovibles disposée à l'intérieur de la structure dans une pluralité de compartiments recevant chacun au moins une unité,
- au moins une alimentation électrique des unités,
est caractérisé en ce qu'elle comprend :
- une partie avant comportant un ensemble de plaques parallèles les unes aux autres, pouvant coulisser à l'intérieur des compartiments et porter une pluralité d'unités à disques disposées cote à côte de part et d'autre d'une partie centrale portant une carte électronique d'adaptateurs à laquelle elles sont connectées, assurant soit la gestion en temps réel des unités à disques de la plaque, soit simplement leur connexion vers les systèmes hôtes,
- une partie arrière comportant notamment l'alimentation électrique de toutes les unités à disques,
- un fond de panier connecté d'une part à chacune des cartes et d'autre par au système hôte par l'intermédiaire de moyens de connexion disposés dans la partie arrière, le dessin des connexions réalisé sur le fond de panier permettant de donner au sous-système une configuration déterminée.

D'autres caractéristiques et avantages de la présente invention apparaitront dans la description suivante donnée à titre d'exemple non limitatif et en se référant aux dessins annexés.

Sur ces dessins :
- Les figures 1 à 3 montrent 3 exemples de sous-systèmes de mémoire de masse pouvant être contenus dans la structure physique selon l'invention,
- La figure 4 est une vue de 3/4 en perspective montrant les différentes parties constitutives essentielles de la structure physique selon l'invention, à savoir ensemble de plaques, tiroirs et alimentations électriques,
- La figure 5 est une vue de 3/4 en perspective, vue de l'avant d'un premier modèle de plaque porteuse d'une pluralité d'unités à disques,
- La figure 6 est une vue de 3/4 prise de l'arrière, d'un second modèle de plaque porteuse d'unités à disques,
- La figure 7 est une vue de 3/4 en perspective du tiroir dans son ensemble, les plaques étant disposées à l'intérieur de celui-ci,
- La figure 8 est une vue de face de la partie arrière de la structure physique selon l'invention,
- La figure 9 montre, de façon détaillée, vue de 3/4 en perspective depuis l'avant, la plaque de la figure 6, montrant plus en détail les différentes parties constitutives de celle-ci,
- La figure 10 montre vue de 3/4 en perspective une carte électronique portant un dispositif adaptateur pouvant être connecté à une pluralité d'unités à disques appartenant à la plaque,
- La figure 11, composée des figures 11A et 11B montre, plus en détail, un bloc d'alimentation électrique de la structure physique selon l'invention,
- La figures 12, composée des figures 12a à 12d montre comment une unité à disques est montée sur son support,
- La figure 13 montre comment des unités à disques sont insérées à l'intérieur d'une plaque puis connectées sur la carte d'adaptateur appartenant à cette dernière,
- La figure 14 composée des figures 14a et 14b montre plus en détail le mécanisme qui permet d'insérer une unité à disques à l'intérieur d'une plaque,
- La figure 15 est une vue de côté en coupe montrant l'ensemble de la structure physique selon l'invention, avec son fond de panier séparant les parties avant et arrière,
- La figure 16 montre comment une plaque déterminée est connectée à au moins un système hôte extérieur,
- La figure 17 montre le système d'alimentation électrique de l'une quelconque des plaques appartenant à la structure physique selon l'invention.

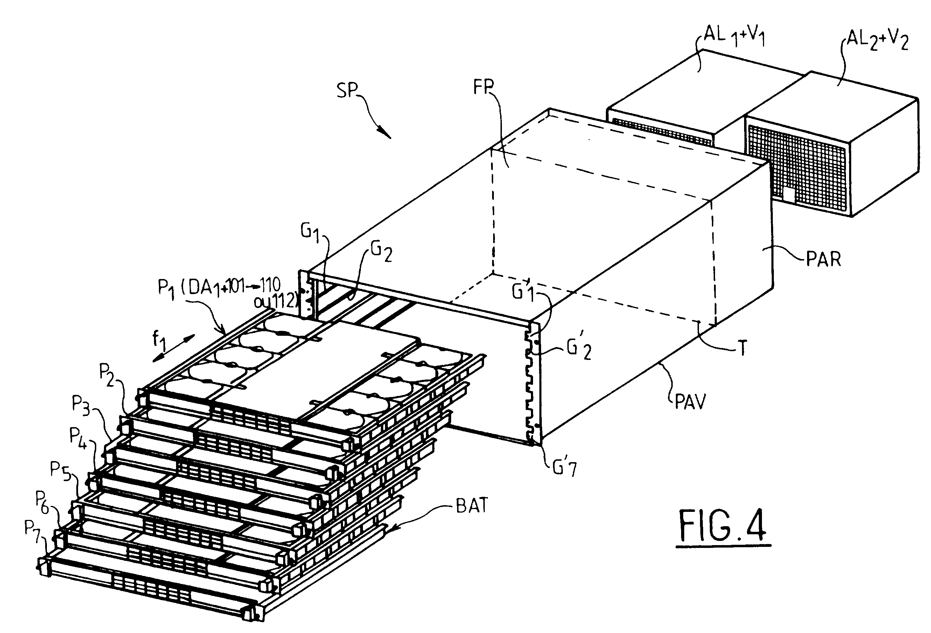

On considère donc les figures 4, 7, 8, 11.

La structure physique SP selon l'invention comprend, ainsi qu'on peut le voir sur ces mêmes figures, un tiroir T de forme parallélépipédique comprenant sur chacune de ses parois latérales, une pluralité de glissières longitudinales parallèles les unes aux autres et disposées les unes au dessus des autres, à savoir le couple de glissières G1-G'1, G2-G'2, et ainsi de suite jusqu'à G7-G'7.

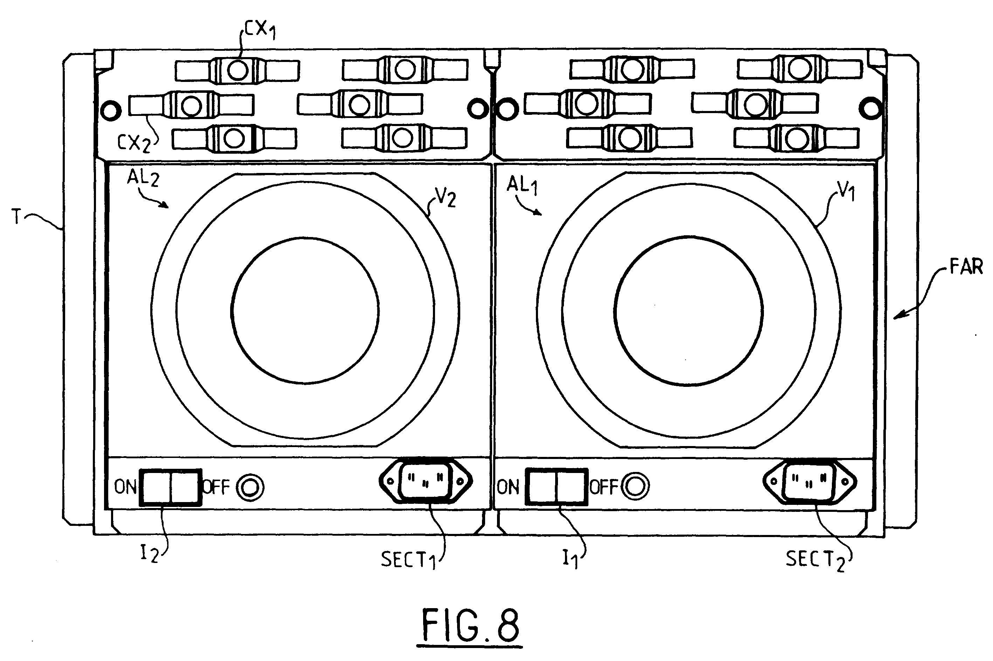

La structure SP comprend par ailleurs une pluralité de plaques P1, P2, ..., P7, parallèles les unes aux autres, relativement plates (de l'ordre de 35mm d'épaisseur chacune) de forme parallèlèpipédique rectangulaire pouvant coulisser chacune à l'intérieur du tiroir T sur les glissières G1-G'1 à G7-G'7. La plaque P1 peut coulisser à l'intérieur du tiroir T sur les glissières G1-G'1 et ainsi de suite, jusqu'à la plaque P7 qui peut coulisser sur les glissières G7-G'7. Cette manière d'insérer les plaques à l'intérieur du tiroir T est extrêmement pratique et permet d'enlever ou d'insérer à volonté, avec une grande facilité de manipulation l'une quelconque d'entre elles. On voit que l'on peut insérer l'une quelconque des plaques P₁ à P₇ à l'intérieur du tiroir T en faisant coulisser la plaque en question d'avant en arrière ou d'arrière en avant, longitudinalement, selon le sens de la flèche f1 parallèle à la longueur du tiroir T. Lorsque toutes les plaques P₁ à P₇ sont insérées, on a alors affaire à la structure globale du tiroir T montrée à la figure 7, de forme extrêmement compacte, et pouvant aussi bien être placée indifféremment en position horizontale comme montré à la figure 7, ou en position verticale. En position verticale, on dit que le tiroir T occupe une position dite "desk-top". Cette disposition verticale est couramment employée par les utilisateurs de micro-ordinateurs. Les plaques P₁ à P₇ s'introduisent par la partie avant du tiroir T à savoir, TAV, alors que la partie arrière PAR se compose de deux alimentations AL₁ et AL₂ munies chacune d'un dispositif de ventilation V₁, V₂. Ces deux blocs d'alimentation, absolument identiques, sont disposés côte à côte dans cette partie arrière. Ils ont la forme chacun d'un bloc parallélépipédique rectangulaire.

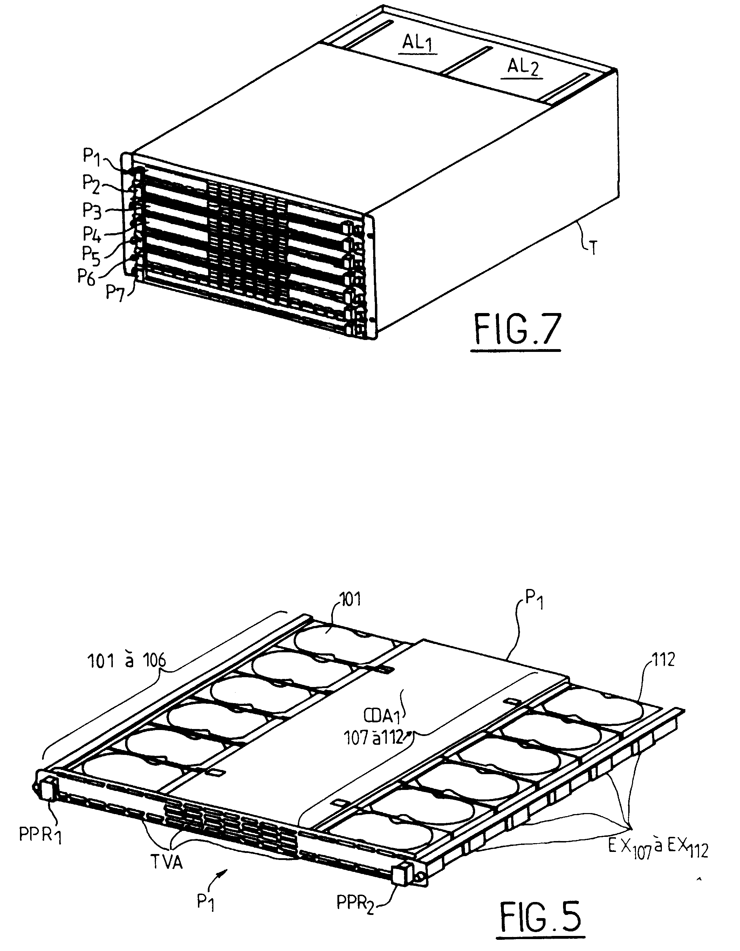

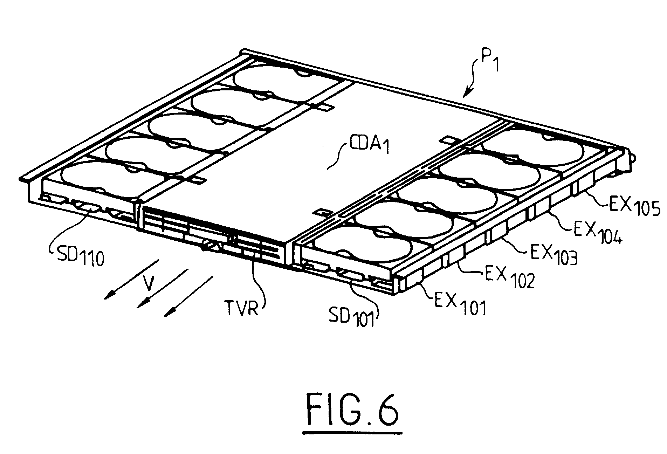

Chacune des plaques P₁ à P₅ (ou P₂ à P₆) porte une pluralité d'unités à disques, qui peuvent être au nombre maximum soit de 12, soit de 10 (parmi les deux types de plaques montrés respectivement aux figures 5 et 6 le premier porte 12 disques et le second 10 disques seulement), soit de 8 dans le cas de disques 3 pouces et demi (3" ½). Si P₁ porte des unités à disques, P₆ porte soit le processeur FCP (SSM₁) soit CT₁-CT₂ (SSM₂) et réciproquement. On supposera donc, par la suite, que P₁ porte des unités à disques.

La plaque P₇ porte un ensemble de batteries de secours BAT.

La partie avant PAV et la partie arrière PAR sont séparées par un fond de panier FP qui porte un certains nombres de connexions électriques et dont la surface est limitée pour laisser passer l'air de ventilation (cette surface est très inférieure à la surface de la section transversale rectangulaire de T).

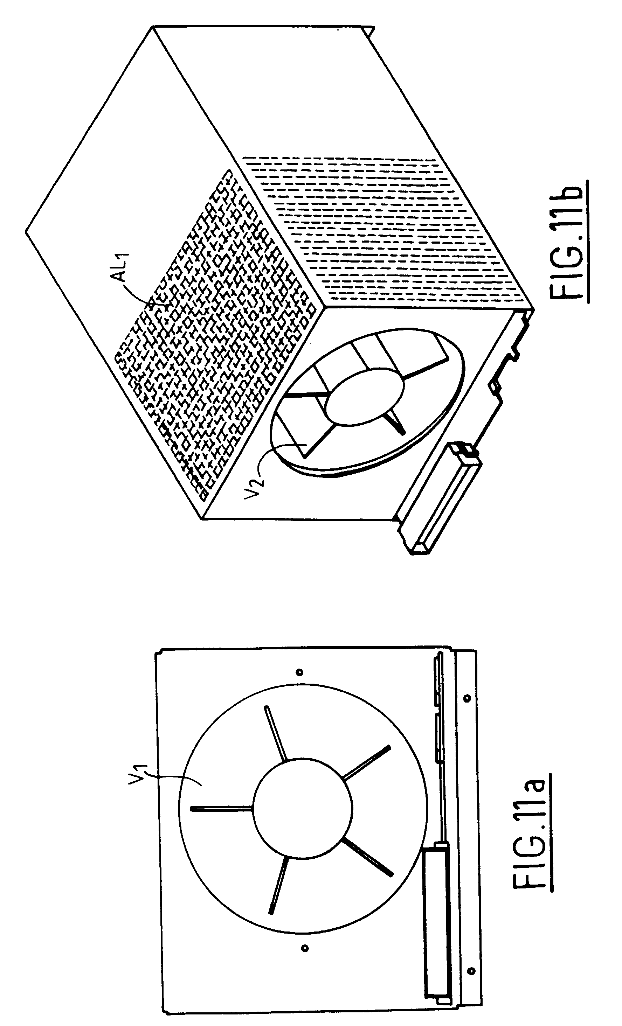

La figure 11, aussi dans sa partie 11a que dans sa partie 11b montre plus en détail le système de ventilation disposé sur la partie arrière du bloc d'alimentation, ce bloc de ventilation étant composé d'un ventilateur à cinq pales.

La face arrière FAR de la partie PAR qu'on peut voir à la figure 8 comprend en outre deux interrupteurs I₁ et I₂ destinés respectivement à la mise en route de chacun des blocs d'alimentation AL₁ et AL₂ et deux prises secteurs SECT₁ et SECT₂ disposées chacune dans la partie droite de chacun des deux blocs d'alimentation.

On considère désormais les figures 5 et 6 qui montrent respectivement vue de l'avant et vue de l'arrière deux exemples de réalisation de la plaque P₁. A la figure 5, P₁ porte 12 mémoires à disques 101 à 112, alors qu'à la figure 6, cette même plaque ne comporte que 10 mémoires à disques 101 à 110. La plaque P₁ comprend de ce fait, deux rangées parallèles de six mémoires à disques (figure 5) ou 5 mémoires à disques (figure 6), à savoir respectivement une première rangée de mémoires à disques 101 à 106 (101 à 105) et une seconde rangée de mémoires à disques 107 à 112 (106 à 110). Ainsi qu'on peut le voir sur ces mêmes figures, ces différentes mémoires à disques sont disposées côte à côte, leurs axes longitudinal étant perpendiculaire à l'axe longitudinal de la plaques P₁.

La plaque P₁ comprend une partie centrale portant la carte électronique CDA1 portant un dispositif adaptateur DA₁, pouvant être l'un quelconque des dispositifs adaptateurs montrés aux figures 1 à 3. Les deux rangées de disques 101 à 106, 107 à 112 (101 à 105, 106 à 110) sont disposées de part et d'autre de cette partie centrale CDA₁. Les unités à disques (on emploiera par la suite, pour simplifier, l'expression "disque" en lieu et place de "unités à disque") de la première rangée sont toutes connectées, d'une manière qui sera indiquée plus loin, sur un même côté de la plaque CDA₁. Cette plaque est de dimension rectangulaire et sa direction longitudinale est la même que la direction longitudinale du tiroir T. De même, les disques de la seconde rangée sont connectés sur la plaque CDA₁ sur un même côté de la carte CDA₁, côté opposé à celui sur lequel sont connectés les disques de la première rangée.

La plaque P₁ comprend sur sa partie avant deux poignées de préhension PPR₁ et PPR₂ permettant à tout opérateur humain d'insérer ou d'extraire plus aisément la plaque en question à l'intérieur du tiroir T. La première poignée à savoir PPR₁ se trouve du côté de la rangée de disques 101 à 106, du côté du bord longitudinal gauche de la plaque P₁, à la figure 5, tandis que la seconde poignée PPR₂ se trouve du côté de la seconde rangée de disques 107 à 112, à côté du bord longitudinal de la plaque P₁ situé sur la partie droite de la figure 5.

Sur les bords longitudinaux de la plaque P₁, on trouve une série de leviers d'extraction permettant d'insérer ou d'extraire les disques de la rangée à laquelle ils sont associés. Ces leviers permettent également de verrouiller les disques de la rangée lorsque ceux-ci ont été mis en place sur la plaque P₁, en facilitant la connexion des disques sur la carte centrale CDA₁. Ainsi, à la figure 6, on peut voir sur la partie droite de la figure, les leviers d'extraction EX₁₀₁ à EX₁₀₅ de bas en haut de la figure, alors qu'à la figure 5, on peut voir les leviers d'extraction EX₁₀₇ à EX₁₁₂ sur la droite de cette figure et de bas en haut.

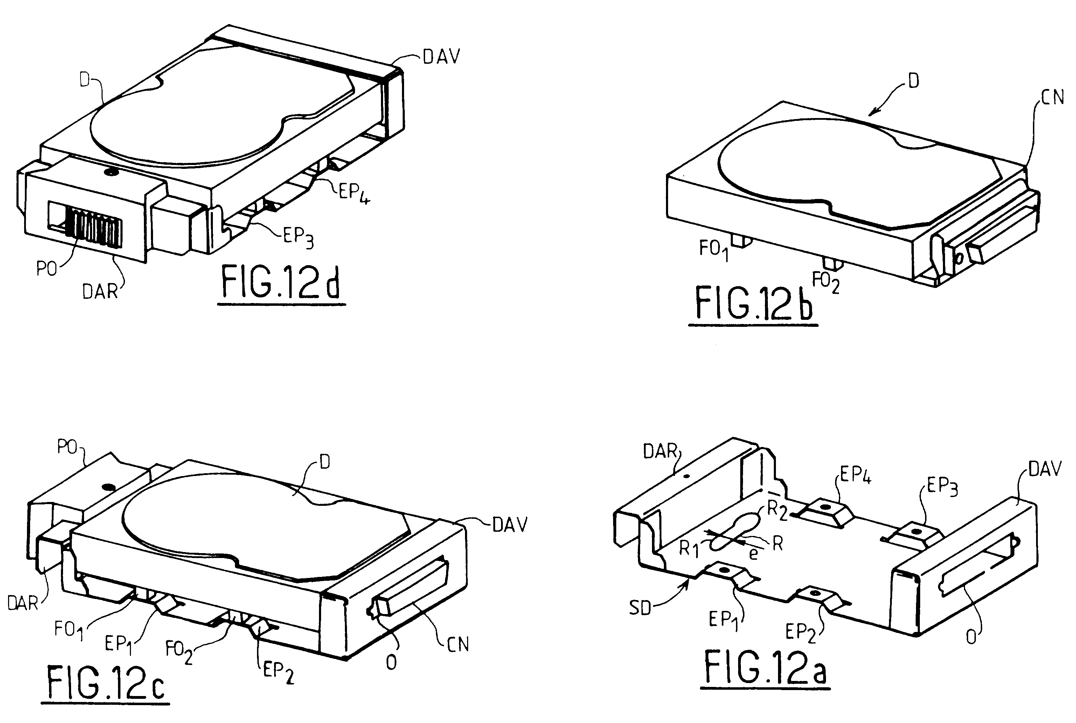

Les leviers EX₁₀₁ à EX₁₀₅ sont associés respectivement aux disques 101 à 105, alors que les leviers EX₁₀₇ à EX₁₁₂ sont respectivement associés aux disques 107 à 112. Il est bien évident qu'il en serait de même pour les leviers non visibles sur les figures 5 et 6 à savoir les leviers EX₁₀₁ à EX₁₀₆ d'une part, et EX₁₀₆ à EX₁₁₀ d'autre part, respectivement associés aux mémoires 101 à 106 et 106 à 110. La manière dont on procède pour insérer (ou extraire) les disques dans la (de) plaque P₁ et les verrouiller de manière à les connecter sur la plaque CDA₁ sera expliquée plus tard, en relation avec les figures 12 à 14.

Sur les figures 5 et 6, on peut voir au centre de la plaque, respectivement sur le bord avant et sur le bord arrière de celle-ci (ceux qui sont respectivement visibles sur ces mêmes figures) une série TVA et une série TVR de trous de ventilation, de forme rectangulaire permettant le passage de l'air de ventilation V dans le sens indiqué par les flèches, ces flèches étant parallèles à la longueur de la plaque P₁, c'est-à-dire à la longueur du tiroir T. L'air de ventilation V aspiré par les ventilateurs V₁ et V₂ se dirige donc d'avant en arrière dans le sens de la longueur des plaques. Il passe au dessus et en dessous des disques 101 à 106 et 107 à 112 (101 à 105, 106 à 110).

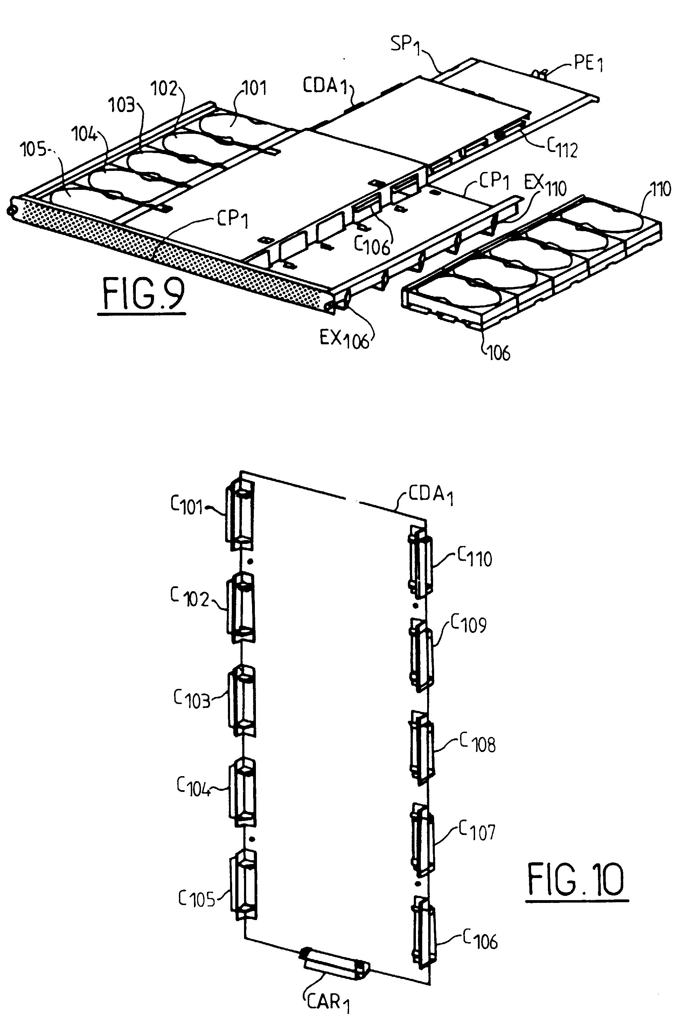

On se reporte désormais aux figures 9 et 10 qui détaillent la manière dont est réalisée la plaque P₁.

A la figure 9, les mémoires 101 à 105 sont représentées insérées dans la plaque P₁ alors que les mémoires 106 à 110 sont représentées non insérées à l'extérieur de P₁ sur la partie droite de la figure. Sur le bord longitudinal droit de P₁, on a représenté les leviers EX₁₀₆ à EX₁₁₀ dans la position qu'ils occupent une fois les mémoires 106 à 110 extraites de la plaque P₁. Dans cette position, qu'on peut appeler position d'extraction, chacun des leviers en question fait un angle déterminé avec le bord longitudinal de la plaque, angle voisin de 30° à la figure 9. Ces leviers peuvent donc effectuer une rotation égale à cet angle, depuis une position où ils sont plaqués contre le bord de la plaque jusqu'à la position d'extraction grâce à une charnière non représentée autour de laquelle ils peuvent pivoter, cette charnière étant perpendiculaire au plan de la plaque P₁. (c'est-à-dire verticale à la figure 9.)

Sur cette même figure 9, on a représenté en partie détachée de la plaque P₁, la carte électronique CDA₁, cette dernière étant disposée sur un support SP₁. Elle peut coulisser sur celui-ci d'avant en arrière ou inversement lorsqu'on veut la retirer ou l'insérer dans celui-ci. Ce support comprend dans sa partie arrière une poignée d'extraction PE₁ permettant de le retirer de la partie centrale de la plaque P₁. (Ceci, par exemple a lieu avant de retirer la carte électronique CDA₁, quand il est nécessaire par exemple de la changer). Cette carte CDA₁ vient s'insérer sous le capot CP₁ disposé dans la partie supérieure de la plaque à la figure 9, au centre de la plaque.

Ainsi qu'on peut le voir à la figure 10, CDA₁ comprend sur chacun de ses deux bords longitudinaux, une pluralité de connecteurs, à savoir les connecteurs C₁₀₁ à C₁₀₅ sur le bord longitudinal gauche et C₁₀₆ à C₁₁₀ sur le bord longitudinal droit. Il est bien évident que la carte CDA₁ pourrait contenir deux fois six connecteurs, à savoir C₁₀₁ à C₁₀₆ sur son bord gauche et C₁₀₇ à C₁₁₂ sur son bord droit si la plaque P₁ contient 12 disques en lieu et place des 10 disques montrés à la figure 9. Tous les connecteurs C₁₀₁ à C₁₁₀ sont identiques et correspondent à la norme utilisée pour le fonctionnement des disques, ici la norme SCSI.

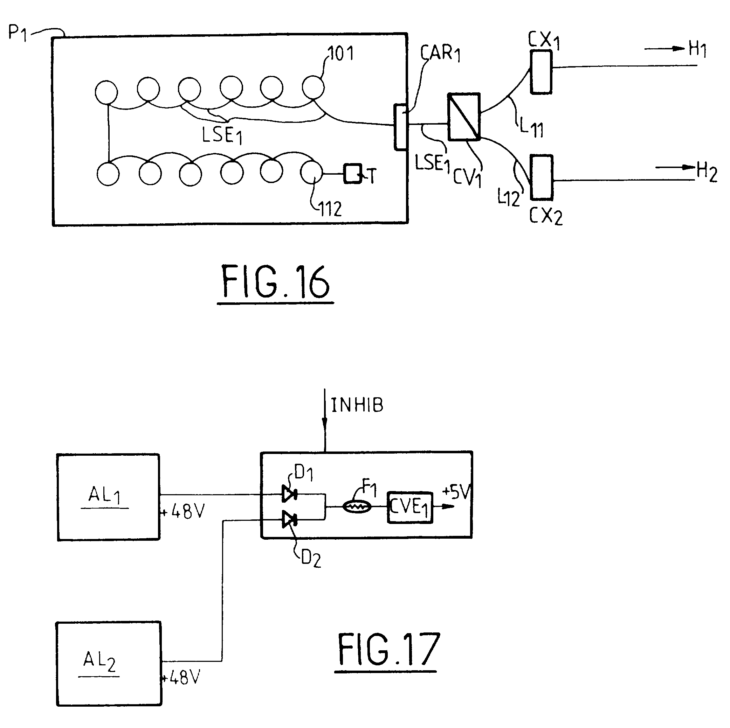

Ainsi qu'on peut le voir à la figure 10, aussi bien sur le bord latéral gauche que sur le bord latéral droit, les différents connecteurs sont régulièrement espacés. De plus, sur la partie arrière de la carte CDA₁, c'est-à-dire sur la partie basse de la figure 10, la dite carte comporte un connecteur arrière, CAR₁ qui permet de la relier, à travers des connexions disposées dans la partie arrière PAR du tiroir T, à au moins un système hôte extérieur. Ceci sera illustré plus particulièrement dans la description ultérieure en relation avec la figure 16.

On considère les figures 12 à 14.

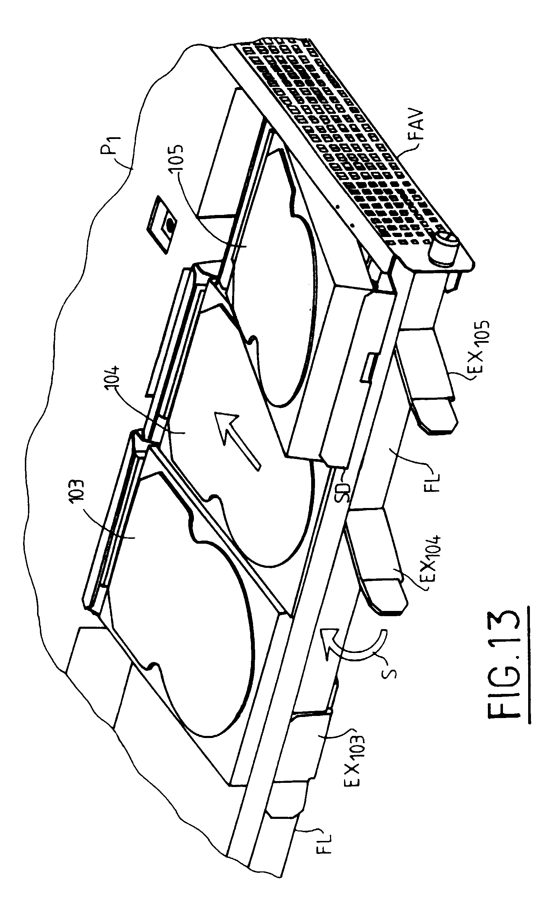

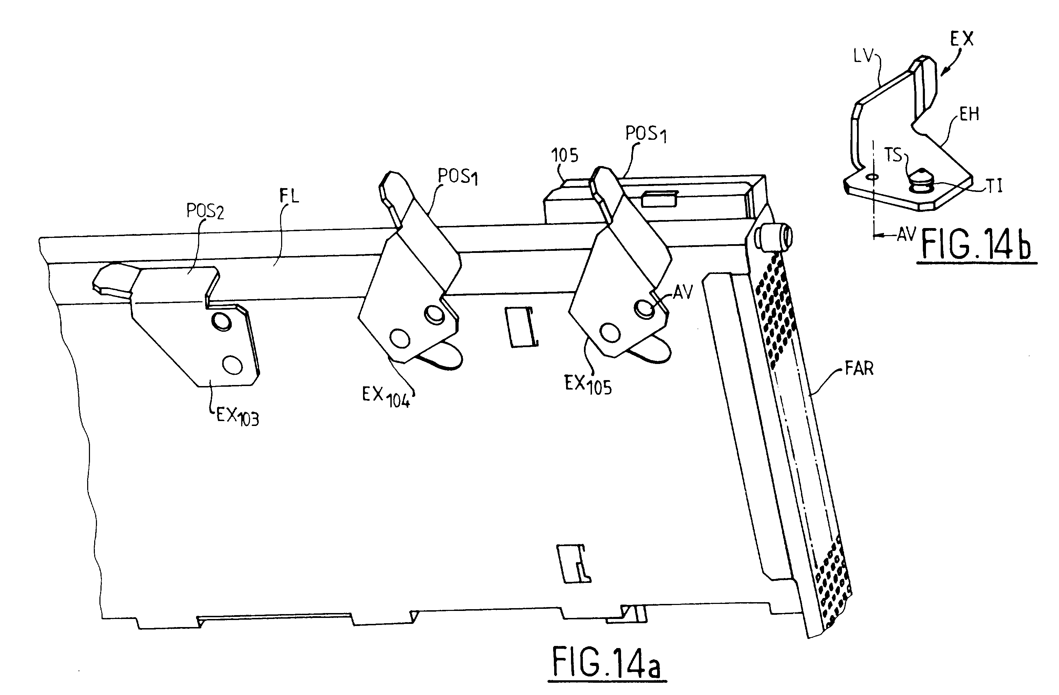

La figure 12 montre, comment un disque D est fixé sur son support SD. bien entendu, le disque D peut être l'un quelconque des disques 101 à 112, 201 à 212, etc, de l'un quelconque des systèmes montrés aux figures 1 à 3. Ce disque est donc muni de 4 pieds disposés sur sa partie inférieure (voir figure 12b) FO₁ à FO₄, les deux premiers seulement étant visibles figure 12b. Le disque comporte encore un connecteur CN destiné à être insérer dans les connecteurs associés de la carte électronique correspondante. On peut donc dire que chacun des disques 101 à 112, 101 à 110 comporte un connecteur CN₁₀₁ à CN₁₁₂ (CN₁₀₁ à CN₁₁₀). Ces connecteurs CN₁₀₁ à CN₁₁₂ par exemple sont destinés à être connectés au connecteur correspondant C₁₀₁ à C₁₁₂ (C₁₀₁ à C₁₁₀) de la plaque P₁. Chacun des connecteurs de type CN est bien entendu conforme à la norme SCSI. Si l'on considère la figure 12a qui montre le support du disque SD, on voit que celui-ci comprend 4 épaulements EP₁, EP₂, EP₃, EP₄ disposés sur chacun des deux bords longitudinaux du support, avec bien entendu deux épaulements sur chacun des bords. Chacun de ces deux épaulements est associé à un pied du disque destiné à être inséré sur le support. L'épaulement EP1 est donc associé au pied FO₁, l'épaulement EP₂ au pied FO₂, etc... Chacun des épaulements comprend en son centre un trou par lequel on peut passer une vis qui viendra s'insérer dans le pied correspondant permettant ainsi la fixation du disque D sur son support. Pour des raisons évidentes de simplicité, ces vis ne sont pas représentées à la figure 12. L'avant du support SD, situé sur la partie droite à la figure 12a comprend une ouverture O à l'intérieur de laquelle vient s'insérer le connecteur CN quand le disque D est monté sur le support. La partie avant du disque DAV est donc celle qui vient en contact avec la partie centrale de la plaque P₁. La partie arrière du disque, ici désignée par DAR, a la forme d'une cornière en L renversé ce qui permet une préhension manuelle extrêmement aisée du support pour les opérations de manipulation de celui-ci. DAR est situé sur la partie gauche de la figure 12a. Le support SD comprend, du côté de la partie arrière, une rainure R dont l'axe est parallèle à l'axe longitudinal de la plaque P₁ quand le disque correspondant est monté sur la plaque (l'axe de R est de fait perpendiculaire à la longueur de SD). Cette rainure comprend deux parties, une partie R₁ et une partie R₂, la partie R₁ ayant une forme rectangulaire terminée par un demi-cercle, ayant une largeur I (I étant mesuré parallèlement à la longueur du support SD) et la partie R₂ attenante à la partie R₁, ayant une forme circulaire de diamètre supérieur à l. L'utilité fonctionnelle de la division en deux parties de la rainure R apparaîtra mieux en relation avec la description des figures 13 et 14.

A la figure 12c, on voit vu de 3/4 en perspective, le disque D monté sur son support, le pied FO₁ étant vissé sur l'épaulement EP₁, le pied FO₂ sur l'épaulement EP₂, le connecteur CN étant disposé à l'intérieur de l'ouverture O. De plus, afin de faciliter les opérations de manipulation du disque D monté sur son support, on peut également voir sur cette même figure 12c une poignée PO qui est montée par vissage sur la partie avant DAR. Cette poignée PO permet de manipuler manuellement avec aisance le disque D lorsqu'il est monté sur son support en vue par exemple de l'insérer dans la plaque (par exemple P₁) où il est monté. Si on considère la figure 12d, on peut apercevoir les épaulements EP₃ et EP₄ sur lesquels sont vissées les poignées PO₃ et PO₄.

On se réfère désormais aux figures 13 et 14.

En particulier, on peut voir à la figure 14b plus en détail, vue de 3/4 en perspective, l'un quelconque des leviers d'extraction ici dénommé EX, ce levier d'extraction pouvant par exemple être l'un quelconque des leviers d'extraction EX₁₀₅, EX₁₀₄, EX₁₀₃, etc... montrés aux figures 14a et 13. On voit sur cette même figure qu'un tel levier comprend une partie que l'on peut considérer comme verticale, que l'on désigne par EV et une partie horizontale que l'on désigne par EH. Lorsqu'il s'agit d'introduire l'un quelconque des disques dans la plaque P₁, cette partie verticale EV est celle que l'opérateur manuel manipule. La partie horizontale EH est montée sur le capot CP₁ de la plaque P₁. Elle est montée sur celui-ci de manière à être libre en rotation autour d'un axe vertical (axe AV, à la figure 14b). Le levier d'extraction EX comprend d'autre part fixé sur sa partie horizontale EH un téton TET comprenant une partie supérieure TS et une partie inférieure cylindrique TI. Cette dernière a un diamètre égal à la largeur I de la partie R1 de la rainure R dans laquelle il vient s'insérer. De cette manière le téton TET par cette partie inférieure peut coulisser parallèlement à l'axe de cette rainure R. La partie supérieure TS a un diamètre qui est très légèrement inférieur au diamètre de la partie T₂ de la rainure R, de manière à pouvoir être introduit dans celle-ci.

Si l'on considère la figure 14a, on voit sur la partie droite de la figure le levier EX₁₀₅ en position d'extraction. Dans cette position, qu'on désigne par POS₁, la partie EV du levier est détachée de la face latérale FL de P₁. Cette partie EV fait avec cette face latérale FL un angle déterminé qui a été mentionné plus haut comme étant de l'ordre de 30° mais qui est volontairement exagéré à la figure 14a à des fins de clarté du dessin. Au centre de la figure, on voit le levier EX₁₀₄ dans la même position POS₁. La différence entre la partie droite de la figure et la partie centrale est que dans la partie droite on a représenté le disque 105 en préposition d'insertion dans la plaque P₁. Sur la partie gauche de la figure 14a, le levier EX₁₀₃ est représenté en position d'insertion, c'est-à-dire POS₂ où la partie EV de ce levier est en contact avec la face latérale FL de la plaque P₁.

Pour introduire un disque quelconque à l'intérieur de la plaque P₁ comme indiqué à la figure 13, on insère le disque, par exemple disque 105 (comme visible sur la partie droite de la figure 13) par sa partie avant DAV de telle façon que en faisant glisser celle-ci vers la carte électronique CDA₁, cette partie avant vient en contact avec le connecteur de la carte correspondant, ici par exemple, le connecteur C₁₀₅. Lors de cette phase de prépositionnement et d'insertion dans la plaque P₁, le disque 105 est incliné par rapport au plan de la plaque P₁. Lorsque le connecteur CN₁₀₅ du disque 105 vient en contact avec le connecteur C₁₀₅, on peut rabattre le disque de telle façon que son support SD soit disposé à plat sur la plaque P₁. Dans ce cas, le disque occupe la position indiquée au centre de la figure 13, position occupée par le disque 104. Le levier d'insertion EX₁₀₅ ou EX₁₀₄ est toujours dans la position d'extraction POS₁. Lorsque le disque est positionné sur la plaque P₁, (comme le disque 104), le téton TET est disposé à l'intérieur de la rainure R et plus précisément à l'intérieur de la partie R₂ de celle-ci. On peut alors faire passer le levier EX₁₀₄ de la position POS₁ à la position POS₂, dite position d'insertion, en faisant tourner le dit levier autour de sa charnière dans le sens de flèche S (voir partie centrale de la figure 13) dans le sens des aiguilles d'une montre. En position finale, le levier d'extraction EX₁₀₃ vient en position POS₂ où sa partie verticale EV est en contact avec la face latérale FL de la plaque P₁. Lorsque le levier passe de POS₁ à POS₂, le téton TET glisse dans la rainure de façon à passer de la partie R2 de celle-ci à la partie R₁ et plus précisément venir en contact avec l'extrémité de celle-ci en forme de demi-cercle (se reporter à la figure 12a également). Lorsque le téton TET vient buter contre cette partie en demi-cercle, le disque (ici 103) est verrouillé et connecté au connecteur C₁₀₃ correspondant (voir partie gauche de la figure 13).

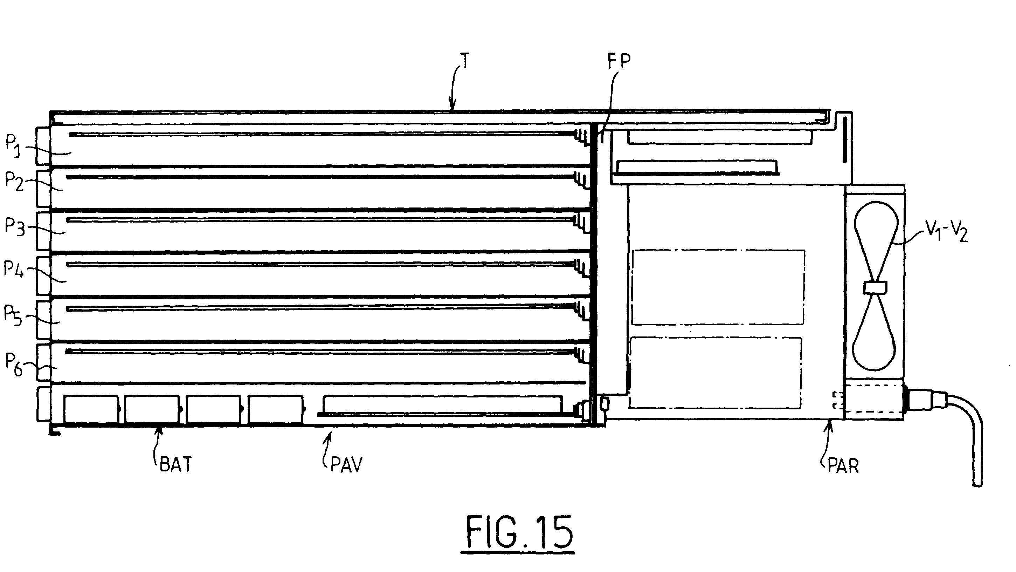

On considère la figure 15.

La partie PAV et la partie arrière PAR du tiroir T sont séparées par un fond de panier FP qui comprend une pluralité de moyens de connexion (qui seront plus détaillés à la figure 16) permettant de relier chacune des plaque P₁ vers des hôtes centraux se situant à l'extérieur du tiroir T. Le fond de panier FP comprend une pluralité de liaisons de connexion entre les différentes plaques qui permettent de réaliser l'un ou l'autre des structures de sous-systèmes de mémoire de masse SSM₁ à SSM₃ qui sont représentées aux figures 1 à 3. Il suffit donc de changer le fond de panier FP pour passer de l'une des structures à l'autre et ceci sans modifier en aucune façon la constitution des plaques P₁ à P₅ ou P₆. On peut donc dire de la sorte, que le tiroir T tel que conçu permet d'accueillir une grande variété de sous-systèmes de mémoire de masse, en pouvant passer de l'un à l'autre aisément sur le site lui- même où est disposé le tiroir en T. On dit en langage anglo-saxon que l'on a à faire à un système "up-gradable".

On se reporte à la figure 16 qui montre comment la plaque P₁ est connectée à deux systèmes hôtes H₁ et H₂. On a représenté sur cette figure les disques 101 à 112 qui sont reliés entre eux par une liaison SCSI de type "Single ended" normalisée. Cette liaison est ici dénommée LSE₁. A l'extérieur du sous-système, les liaisons de type SCSI sont en mode différentiel. Il y a donc lieu de disposer dans le sous-système, et pour chaque plaque, un convertisseur CV₁ (CV₂,......, CV₆) permettant d'assurer la transition entre la liaison en mode "single-ended" LSE₁ et les liaisons extérieures en mode différentiel.

A la figure 6, ces liaisons sont L₁₁ et L₁₂ permettant respectivement de relier les disques de P₁ par l'intermédiaire de CV₁ d'une part à un connecteur CX₁ relié à un premier hôte central H1 et d'autre part à un connecteur CX2 lui-même connecté à un second hôte central H2. Les connecteurs CX1 et CX2 sont normalisés, ainsi que les liaisons L₁₁ et L₁₂. CV₁ est reliée à la plaque P₁ par l'intermédiaire de LSE₁ et du connecteur CAR₁. Si l'on se reporte à la figure 15, on peut noter que le fond FP comprend une pluralité de connecteurs CAR₁, CAR₂, etc. Par ailleurs, en se reportant à la figure 8, qui montre la face arrière FAR du tiroir T, on peut apercevoir sur la partie supérieure gauche de cette même figure les deux connecteurs CX₁ et CX₂. La face arrière FAR comprend par ailleurs l'ensemble des connecteurs des autres plaques P₂ à P₅ ou P₆. Il y a donc place pour 12 connecteurs à la figure 8.

On se reporte à la figure 17 qui montre de façon fort simplifiée le schéma d'alimentation électrique des différentes plaques. Ainsi, qu'il a été dit plus haut, le tiroir T comprend deux alimentations identiques AL₁ et AL₂ qui sont reliées, pour chaque plaque de type P₁ à respectivement deux diodes D₁ et D₂ elle-même reliées à un fusible F₁ lui-même connecté à un convertisseur électrique CVE₁. Les deux alimentations AL₁ délivrent une tension continue de 48 volts, alors que le convertisseur CVE₁ délivre une tension de + 5 volts. Il assure donc la conversion de 48 à 5 volts.

Il est évident que si un incident survient, par exemple excès de courant ou excès de tension, le fusible F₁ assure une protection pour la plaque P₁. Etant donné qu'il en est de même pour chacune des plaques, on voit que seule l'une d'entre elles peut être affectée par une surtension ou une surintensité, les autres pouvant continuer à fonctionner. Il suffit donc de changer le fusible tel que F₁, de la plaque considérée pour remettre en fonctionnement la plaque affectée par cet incident. Par ailleurs, on peut enlever toutes les plaques P₁ à P₆ sans avoir besoin de couper l'alimentation électrique des autres plaques, le convertisseur CVE1 étant équipé d'une entrée d'inhibition INHIB commandée par un interrupteur manipulé manuellement par l'opérateur, (ceci pour chacune des plaques P1 à P6) et situé sur la partie avant du tiroir T.

## Revendications

1. Structure physique (T) d'un sous-système de mémoire de masse (SSM₁ à SSM₃) reliée à au moins un système hôte (H₁, H₂) comprenant :
- une pluralité de groupements d'unités à disques (101 à 112, 201 à 212,..., 601 à 612) disposés à l'intérieur de la structure, dans une pluralité de compartiments recevant chacun au moins une unité, et
- au moins une alimentation électrique des unités (AL₁, AL₂),
caractérisée en ce qu'elle comprend :
- une partie avant (PAV) comportant un ensemble de plaques parallèles les unes aux autres (P₁ à P₆), pouvant coulisser à l'intérieur des compartiments et porter une pluralité d'unités à disques disposées côte à côte de part et d'autre d'une partie centrale (CDA₁) portant une carte électronique à laquelle elles sont connectées, cette dernière assurant soit la gestion en temps réel des unités à disques de la plaque, soit simplement leur connexion vers le système hôte.
- une partie arrière (PAR) comportant notamment l'alimentation électrique,
- un fond de panier (FP) connecté d'une part à chacune des cartes électroniques des plaques et d'autre part au système hôte (H₁) par l'intermédiaire de moyens de connexion disposés dans la partie arrière (CAR, CX₁, CX₂) le dessin des connexions réalisé sur le fond de panier permettant de donner au sous-système une configuration déterminée (SSM₁, SSM₂, SSM₃).

2. Structure physique selon la revendication 1, caractérisée en ce que à l'intérieur d'une plaque, les unités à disques sont réparties en deux rangées parallèles l'une à l'autre, les différentes unités à disques constituant chaque rangée étant disposées côte à côte, leur axe longitudinal étant perpendiculaire à l'axe longitudinal de la plaque (101 à 106, d'une part, 107 à 112 d'autre part).

3. Structure selon la revendication 2, caractérisée en ce que chaque unité à disques d'une rangée est munie de moyens de connexion (CN₁₀₁ à CN₁₀₆, CN₁₀₇ à CN₁₁₂) disposés du côté de la carte électronique, qui sont connectés à des moyens de connexion correspondants appartenant à la dite carte électronique, les moyens de connexion de celle-ci (C₁₀₁ à C₁₀₆, C₁₀₇ à C₁₁₂) étant fixés sur les côtés longitudinaux de la carte, en étant régulièrement espacés sur celle-ci.

4. Structure physique selon l'une des revendications 2, 3, caractérisée en ce que la partie arrière (PAR) comporte des moyens de ventilation (V₁, V₂) montés à l'intérieur de l'alimentation électrique (AL₁,AL₂), permettant d'assurer la ventilation de celle-ci et de l'ensemble des plaques, chaque plaque comportant sur son bord avant disposé vers l'extérieur du tiroir (T) et sur son bord arrière disposé du côté du fond de panier (FP) des trous de ventilation régulièrement espacés (TVA, TVR) permettant le passage de l'air de ventilation dans un sens parallèle à la longueur de chaque plaque, cet air de ventilation (V) circulant d'avant en arrière dans un sens parallèle à la longueur des plaques.

5. Structure selon l'une des revendications 2, 3 caractérisée en ce que chaque plaque (P₁ à P₆), comporte sur chacun de ses bords longitudinaux des leviers d'extraction et d'insertion de chaque unité à disques d'une rangée (EX₁₀₁ à EX₁₀₅, EX₁₀₆ à EX₁₁₀), pouvant occuper deux positions, une première position dite d'extraction (POS₁) et une seconde position dite d'insertion (POS₂), les leviers pouvant effectuer une rotation autour d'une charnière perpendiculaire au plan de la plaque, permettant de passer de la position d'extraction à la position d'insertion, l'unité à disques associée au levier étant soit extérieure à la plaque, soit non connectée à la carte électronique lorsque le levier est dans la première position, et étant connectée à cette même carte lorsque le levier est dans la seconde position.

6. Structure selon la revendication 5, caractérisée en ce que chaque unité à disques est montée sur une support par l'intermédiaire de moyens de fixation, ceux-ci comprenant d'une part une pluralité de pieds (FO₁ à FO₄) disposés sur la partie inférieure du disque, et d'autre part des épaulements appartenant au support destinés à venir en contact avec les dits pieds, et des moyens de liaison entre les pieds et les épaulements, chaque support comportant dans sa partie avant une ouverture (O) à l'intérieur de laquelle vient s'insérer le connecteur (CN₁₀₁ à CN₁₁₀ ou CN₁₁₂) du disque quant ce dernier est monté sur son support.

7. Structure selon la revendication 6, caractérisée en ce que le support (SD) comprend du côté de sa partie arrière, une rainure (R) dont l'axe est parallèle à l'axe longitudinal de la plaque (P₁ à P₆) quand l'unité à disque correspondante est montée sur celle-ci, la rainure comprenant une première partie (R₁) et une seconde partie (R₂) contiguës, la première ayant une forme rectangulaire terminée par un demi-cercle de largeur donnée (I) et la seconde ayant une forme circulaire de diamètre supérieur à (I).

8. Structure selon la revendication 7, caractérisée en ce que chaque levier d'extraction et d'insertion (EX₁₀₁ à EX₁₁₂) comprend une partie verticale (EV) et une partie horizontale (EH), la partie verticale (EV) étant manipulée par un opérateur, alors que la partie horizontale (EH), comprend un téton (TET) pouvant être introduit dans la seconde partie (R₂) de la rainure (R) et pouvant coulisser parallèlement à l'axe de cette rainure (R) de telle façon qu'en passant de la position où il est à l'intérieur de la seconde partie (R₂) à la position où il est à l'intérieur du demi-cercle de la première partie (R₁), le levier d'extraction correspondant passe de la première position d'extraction (POS₁) à la position d'insertion (POS₂).

## Patentansprüche

1. Physische Struktur (T) eines Massenspeicher-Untersystems (SSM₁ bis SSM₃), die mit wenigstens einem Hostsystem (H₁, H₂) verbunden ist, mit:
- mehreren Gruppen von Plattenlaufwerken (101 bis 112, 201 bis 212, ..., 601 bis 612), die innerhalb der Struktur in mehreren Fächern, die jeweils wenigstens eine Einheit aufnehmen, angeordnet sind, und
- wenigstens einer Stromversorgung (AL₁, AL₂) für die Einheiten,
dadurch gekennzeichnet, daß sie enthält:
- einen vorderen Teil (PAV), der eine Gesamtheit von zueinander parallelen Platten (P₁ bis P₆) enthält, die in den Fächern gleiten und mehrere Plattenlaufwerke tragen können, die beiderseits eines Mittelteils (CDA₁) angeordnet sind, der eine elektronische Karte trägt, an die sie angeschlossen sind, wobei diese letztere entweder das Echtzeit-Management der Plattenlaufwerke der Platte oder einfach ihren Anschluß an das Hostsystem sicherstellt,
- einen hinteren Teil (PAR), der insbesondere die Stromversorgung enthält,
- einen Verdrahtungsrahmenboden (FP), der einerseits an jede der elektronischen Karten der Platten und andererseits an das Hostsystem (H₁) über im hinteren Teil angeordnete Anschlußmittel (CAR, CX₁, CX₂) angeschlossen ist, wobei das Muster der auf dem Verdrahtungsrahmenboden verwirklichten Anschlüsse ermöglicht, dem Untersystem eine bestimmte Konfiguration (SSM₁, SSM₂, SSM₃) zu verleihen.

2. Physische Struktur nach Anspruch 1, dadurch gekennzeichnet, daß in jeder Platte die Plattenlaufwerke in zwei zueinander parallelen Reihen verteilt sind, wobei die verschiedenen Plattenlaufwerke (101 bis 106 einerseits, 107 bis 112 andererseits), die jede Reihe bilden, nebeneinander angeordnet sind, wobei ihre Längsachse zur Längsachse der Platte senkrecht ist.

3. Struktur nach Anspruch 2, dadurch gekennzeichnet, daß jedes Plattenlaufwerk einer Reihe mit Anschlußmitteln (CN₁₀₁ bis CN₁₀₆, CN₁₀₇ bis CN₁₁₂) versehen ist, die auf der Seite der elektronischen Karte angeordnet sind und an entsprechende Anschlußmittel, die zur elektronischen Karte gehören, angeschlossen sind, wobei deren Anschlußmittel (C₁₀₁ bis C₁₀₆, C₁₀₇ bis C₁₁₂) an den Längsseiten der Karte befestigt sind und an dieser gleichmäßig beabstandet sind.

4. Physische Struktur nach einem der Ansprüche 2, 3, dadurch gekennzeichnet, daß der hintere Teil (PAR) Belüftungsmittel (V₁, V₂) enthält, die in der Stromversorgung (AL₁, AL₂) angebracht sind und ermöglichen, die Belüftung der Stromversorgung und der Gesamtheit der Platten sicherzustellen, wobei jede Platte an ihrem vorderen Rand, der vom Schubfach (T) nach außen weist, und an ihrem hinteren Rand, der sich auf seiten des Verdrahtungsrahmenbodens (FP) befindet, regelmäßig beabstandete Belüftungslöcher (TVA, TVR) aufweist, die den Durchgang von Belüftungsluft parallel zur Längsrichtung jeder Platte ermöglichen, wobei diese Belüftungsluft (V) parallel zur Längsrichtung der Platten von vorn nach hinten strömt.

5. Struktur nach einem der Ansprüche 2, 3, dadurch gekennzeichnet, daß jede Platte (P₁ bis P₆) an jeder ihrer Längskanten Entnahme- und Einschubgriffe (EX₁₀₁ bis EX₁₀₅, EX₁₀₆ bis EX₁₁₀) für jedes Plattenlaufwerk einer Reihe aufweist, die zwei Positionen einnehmen können, nämlich eine erste sogenannte Entnahmeposition (POS₁) und eine zweite sogenannte Einschubposition (POS₂), wobei die Griffe eine Drehung um ein zur Ebene der Platte senkrechtes Scharnier ausführen können, die ermöglicht, von der Entnahmeposition in die Einschubposition zu wechseln, wobei das dem Griff zugeordnete Plattenlaufwerk sich entweder außerhalb der Platte befindet oder nicht an die elektronische Karte angeschlossen ist, wenn sich der Hebel in der ersten Position befindet, und an diese Karte angeschlossen ist, wenn sich der Hebel in der zweiten Position befindet.

6. Struktur nach Anspruch 5, dadurch gekennzeichnet, daß jedes Plattenlaufwerk über Befestigungsmittel an einem Träger angebracht ist, der einerseits mehrere Füße (FO₁ bis FO₄), die im unteren Teil der Platte angeordnet sind, und andererseits Schultern enthält, die zum Träger gehören und dazu vorgesehen sind, mit diesen Füßen in Kontakt zu gelangen, und Mittel für eine Verbindung zwischen den Füßen und den Schultern aufweist, wobei jeder Träger in seinem vorderen Teil eine Öffnung (O) aufweist, in die die Anschlußeinrichtung (CN₁₀₁ bis CN₁₁₀ oder CN₁₁₂) der Platte eingeschoben ist, wenn diese letztere an ihrem Träger angebracht ist.

7. Struktur nach Anspruch 6, dadurch gekennzeichnet, daß der Träger (SD) auf seiten seines hinteren Teils eine Rinne (R) aufweist, deren Achse zur Längsachse der Platte (P₁ bis P₆) parallel ist, wenn das entsprechende Plattenlaufwerk an dieser angebracht ist, wobei die Rinne einen ersten Teil (R₁) und einen zweiten, angrenzenden Teil (R₂) enthält, wovon der erste eine rechtwinklige Form besitzt und durch einen Halbkreis mit gegebener Breite (I) abgeschlossen ist und wovon der zweite eine Kreisform mit einem Durchmesser, der größer als (I) ist, besitzt.

8. Struktur nach Anspruch 7, dadurch gekennzeichnet, daß jeder Entnahme- und Einschubgriff (EX₁₀₁ bis EX₁₁₂) einen vertikalen Teil (EV) und einen horizontalen Teil (EH) besitzt, wobei der vertikale Teil (EV) durch eine Bedienungsperson betätigt wird, während der horizontale Teil (EH) einen Ansatz (TET) enthält, der in den zweiten Teil (R₂) der Rinne (R) eingeführt werden kann und parallel zur Achse dieser Rinne (R) in der Weise gleiten kann, daß bei einem Wechsel von der Position, in der er sich im zweiten Teil (R₂) befindet, zu der Position, in der er sich im Halbkreis des ersten Teils (R₁) befindet, der entsprechende Entnahmehebel von der ersten Entnahmeposition (POS₁) zur Einschubposition (POS₂) wechselt.

## Claims

1. Physical structure (T) of a bulk memory sub-system (SSM₁ to SSM₃) connected to at least one host system (H₁, H₂) comprising:
- a plurality of groupings of disk units (101 to 112, 201 to 212, ..., 601 to 612) arranged within the structure, in a plurality of compartments each receiving at least one unit, and
- at least one electric power supply for the units (AL₁, AL₂),
characterised in that it comprises:
- a front portion (PAV) comprising a set of plates parallel to each other (P₁ to P₆), capable of sliding inside compartments and carrying a plurality of disk units arranged side by side on either side of a central portion (CDA₁) carrying an electronic board to which they are connected, the latter ensuring either real-time management of the disk units of the plate, or simply their connection to the host system,
- a rear portion (PAR) comprising in particular the electric power supply,
- a backplane (FP) connected on the one hand to each of the electronic boards of the plates and on the other hand to the host system (H₁) via connection means arranged in the rear portion (CAR, CX₁, CX₂), the design of the connections made to the backplane making it possible to give the sub-system a predetermined configuration (SSM₁, SSM₂, SSM₃).

2. Physical structure according to Claim 1, characterised in that, within a plate, the disk units are divided into two rows parallel to each other, the different disk units constituting each row being arranged side by side, their longitudinal axis being perpendicular to the longitudinal axis of the plate (101 to 106, on the one hand, 107 to 112 on the other hand).

3. Structure according to Claim 2, characterised in that each disk unit in a row is provided with connection means (CN₁₀₁ to CN₁₀₆, CN₁₀₇ to CN₁₁₂) arranged at the side of the electronic board, which are connected to corresponding connection means belonging to said electronic board, the connection means thereof (C₁₀₁ to C₁₀₆, C₁₀₇ to C₁₁₂) being fixed on the longitudinal sides of the board, while being spaced out evenly thereon.

4. Physical structure according to one of Claims 2, 3, characterised in that the rear portion (PAR) comprises ventilation means (V₁, V₂) mounted within the electric power supply (AL₁, AL₂), making it possible to ensure ventilation for said power supply and for all the plates, each plate comprising on its front edge, arranged towards the outside of the tray (T) and on its rear edge, arranged on the backplane side (FP), evenly spaced ventilation holes (TVA, TVR) allowing ventilation air to pass through in a direction parallel to the length of each plate, this ventilation air (V) flowing from front to back in a direction parallel to the length of the plates.

5. Structure according to one of Claims 2, 3 characterised in that each plate (P₁ to P₆) comprises, on each of its longitudinal edges, levers for extracting and inserting each disk unit of a row (EX₁₀₁ to EX₁₀₅, EX₁₀₆ to EX₁₁₀), which can occupy two positions, a first "extraction" position (POS₁) and a second "insertion" position (POS₂), the levers being able to effect a rotation about a hinge perpendicular to the plane of the plate, making it possible to pass from the extraction position into the insertion position, the disk unit associated with the lever being either external to the plate, or not connected to the electronic board when the lever is in the first position and being connected to that same board when the lever is in the second position.

6. Structure according to Claim 5, characterised in that each disk unit is mounted on a support via fastening means, these comprising on the one hand a plurality of feet (F0₁ to F0₄) arranged on the lower portion of the disk and, on the other hand, shoulders belonging to the support intended to come into contact with said feet, and connection means between the feet and the shoulders, each support comprising, in its front portion, an opening (0) inside which is inserted the connector (CN₁₀₁ to CN₁₁₀ or CN₁₁₂) for the disk when the latter is mounted on its support.

7. Structure according to Claim 6, characterised in that the support (SD) comprises, on the side of its rear portion, a slot (R) the axis of which is parallel to the longitudinal axis of the plate (P₁ to P₆) when the corresponding disk unit is mounted thereon, the slot comprising a first portion (R₁) and a second portion (R₂), the two portions being contiguous, the first having a rectangular form terminated by a semicircle of a given length (1) and the second having a circular form of a diameter greater than (1).

8. Structure according to Claim 7, characterised in that each extraction and insertion lever (EX₁₀₁ to EX₁₁₂) comprises a vertical portion (EV) and a horizontal portion (EH), the vertical portion (EV) being manipulated by an operator, while the horizontal portion (EH) comprises a spigot (TET) that can be introduced into the second portion (R₂) of the slot (R) and being able to slide parallel to the axis of this slot (R) in such a way that, passing from the position where it is inside the second portion (R₂) to the position where it is inside the semicircle of the first portion (R₁), the corresponding extraction lever passes from the first extraction position (POS₁) to the insertion position (POS₂).
